(19) Europäisches Patentamt
European Patent Office
Office européen des brevets

(11) Veröffentlichungsnummer: **0 036 075**
**B1**

# (12) EUROPÄISCHE PATENTSCHRIFT

(45) Veröffentlichungstag der Patentschrift: **06.06.84**

(51) Int. Cl.³: **C 08 F 2/50**, G 03 C 1/68, C 09 D 11/10

(21) Anmeldenummer: **81100925.7**

(22) Anmeldetag: **10.02.81**

(54) **Neue Gemische auf Basis von aromatisch-aliphatischen Ketonen, ihre Verwendung als Photoinitiatoren sowie photopolymerisierbare Systeme enthaltend solche Gemische.**

(30) Priorität: **15.03.80 DE 3010148**

(43) Veröffentlichungstag der Anmeldung: **23.09.81 Patentblatt 81/38**

(45) Bekanntmachung des Hinweises auf die Patenterteilung: **06.06.84 Patentblatt 84/23**

(84) Benannte Vertragsstaaten: **AT BE CH DE FR GB IT LI NL SE**

(56) Entgegenhaltungen:
**FR - A - 2 353 623**
**FR - A - 2 391 183**

**Die Akte enthält technische Angaben, die nach dem Eingang der Anmeldung eingereicht wurden und die nicht in dieser Patentschrift enthalten sind.**

(73) Patentinhaber: **Merck Patent Gesellschaft mit beschränkter Haftung, Frankfurter Strasse 250, D-6100 Darmstadt (DE)**

(72) Erfinder: **Eichler, Jürgen, Dr., Mainzer Strasse 14, D-6108 Weiterstadt 1 (DE)**
Erfinder: **Herz, Claus, Dr., Berghalde 20, D-6900 Heidelberg (DE)**
Erfinder: **Neisius, Karl-Heinz, Dr., Kattreinstrasse 76, D-6100 Darmstadt (DE)**

**EP 0 036 075 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

BUNDESDRUCKEREI BERLIN

**Beschreibung**

Die Erfindung betrifft neue, als Photoinitiatoren verwendbare Gemische auf Basis von aromatisch-aliphatischen Ketonen und ihre Verwendung als Photoinitiatoren, insbesondere für die Photopolymerisation ethylenisch ungesättigter Verbindungen und für die UV-Härtung von Druckfarben sowie photopolymerisierbare Systeme enthaltend solche Gemische.

Photochemisch initiierte Polymerisationsreaktionen haben in der Technik große Bedeutung erlangt, insbesondere wenn es um eine schnelle Härtung von dünnen Schichten geht, wie z. B. bei der Härtung von Lack- und Harzüberzügen auf Papier, Metall und Kunststoff oder bei der Trocknung von Druckfarben, da diese Verfahren sich gegenüber konventionellen Methoden zum Bedrucken und Beschichten von Gegenständen durch Rohstoff- und Energieersparnis und eine geringere Umweltbelastung auszeichnen. Da bei diesen Reaktionen in der Regel keiner der Reaktionspartner in der Lage ist, die photochemisch wirksame Strahlung in ausreichendem Maße zu absorbieren, müssen sogenannte Photoinitiatoren zugesetzt werden, die in der Lage sind, eingestrahltes Licht oder UV zu absorbieren und im angeregten Zustand aktive Starterradikale zu bilden. Je nach Art der Weiterreaktion aus dem angeregten Zustand heraus unterscheidet man dabei zwei Gruppen: Eine Reihe von Verbindungen zerfallen nach der energetischen Anregung direkt in aktive Starterradikale, die ihrerseits die Polymerisation auslösen, während andere Verbindungen im angeregten Zustand erst mit einer weiteren Verbindung reagieren, um aktive Starterradikale zu bilden, die dann die Polymerisation auslösen. Beide Arten von Verbindungen werden im folgenden unter dem Begriff Initiatoren zusammengefaßt. Wesentliche Kriterien für die Auswahl solcher Initiatoren sind unter anderem die Art der durchzuführenden Reaktion, das Verhältnis des Absorptionsspektrums des Initiators zur spektralen Energieverteilung der verfügbaren Strahlenquelle, die Löslichkeit des Initiators in der Reaktionsmischung, die Dunkellagerstabilität des mit dem Initiator versetzten Reaktionssystems sowie die Beeinflussung der Endprodukte durch darin verbliebene Reste des Initiators und/oder der daraus während der photochemischen Reaktion entstandenen Produkte. Insbesondere die Geschwindigkeit der Reaktion hängt stark vom verwendeten Initiator ab. Deshalb hat es nicht an Versuchen gefehlt, neue Initiatorgemische zu suchen, die in ihrem Vermögen, die Photopolymerisation ethylenisch ungesättigter Verbindungen bzw. die Härtung photopolymerisierbarer Systeme zu initiieren, eine gesteigerte Reaktivität zeigen.

Als Initiatoren für die Photopolymerisation ungesättigter Verbindungen sind bisher hauptsächlich Benzophenonderivate, Benzoinether, Benzilmonoketale, Dibenzosuberonderivate, Anthrachinone, Xanthone, Thioxanthone und a-Halogenacetophenonderivate eingesetzt worden. Die technische Anwendbarkeit dieser Substanzen wird jedoch durch eine Reihe von Nachteilen deutlich eingeschränkt. Hierzu gehören u. a. geringe Dunkellagerstabilität von vielen photopolymerisierbaren Systemen, die mit diesen Initiatoren versetzt sind, geringe chemische Stabilität und zu geringe Reaktivität im Vermögen, die Photopolymerisation ethylenisch ungesättigter Verbindungen bzw. die Härtung photopolymerisierbarer Systeme zu initiieren. Viele dieser bekannten Initiatoren bewirken eine Vergilbung der mit ihnen hergestellten Polymerisate, die besonders bei der Beschichtung heller Untergrundmaterialien und bei UV-gehärteten Druckfarben höchst unerwünscht ist. Für dieses zuletzt genannte Anwendungsgebiet ist auch die oft geringe Löslichkeit der bekannten Initiatoren in dem photopolymerisierbaren System ein großer Nachteil. Da Druckfarben in der Regel beträchtliche Mengen farbiger Pigmente enthalten, die einen großen Teil der eingestrahlten Energie absorbieren, ohne daß er photochemisch wirksam wird, muß hier eine größere Menge Initiator zugesetzt werden. Dabei kristallisieren die bekannten Initiatoren häufig teilweise aus; abgesehen davon, daß die auskristallisierten Anteile nicht mehr initiierend wirksam werden können, beschädigen die entstandenen Kristallite auch nach einiger Zeit die aus relativ weichen Materialien bestehenden Druckplatten.

Weiterhin werden in der deutschen Offenlegungsschrift 2 722 264 eine Reihe von Hydroxyalkylphenonen als Photoinitiatoren beschrieben, die die Nachteile der bis dahin bekannten Initiatoren in wesentlich geringerem Maße aufweisen. Diese zum Teil flüssigen Verbindungen sind in den üblichen photopolymerisierbaren Systemen deutlich besser löslich als die meisten bis dahin bekannten, in der Regel festen Initiatoren und besitzen eine gute Dunkellager- und chemische Stabilität. Insbesondere aber wird bei Photopolymerisation mit diesen Initiatoren Vergilbung der Polymerisate nur in wesentlich geringerem Ausmaß als bei den bis dahin gebräuchlichen Initiatoren beobachtet. Doch trotz der gesteigerten photoinitiierenden Wirksamkeit dieser Hydroxyalkylphenone im Vergleich zu den übrigen bekannten Initiatoren weisen auch diese Verbindungen noch eine ungenügende Reaktivität bei der Initiierung der Photopolymerisation auf. Dadurch sind immer noch relativ lange Härtungszeiten erforderlich, was zu einer nicht optimalen Ausnutzung der UV-Bestrahlungsanlagen führt.

Es bestand daher die Aufgabe, Photoinitiatoren, insbesondere für die Photopolymerisation ethylenisch ungesättigter Verbindungen bzw. für die Härtung photopolymerisierbarer Systeme zu finden, die physiologisch unbedenklich sind, im Gemisch mit den anderen Reaktionspartnern eine ausreichende Dunkellagerstabilität besitzen, die selbst oder durch ihre Folgeprodukte keine Vergilbung der Reaktionsprodukte verursachen, die in den üblichen photopolymerisierbaren Systemen eine möglichst hohe Löslichkeit aufweisen, die eine geringe Oberflächenklebrigkeit der ausgehärteten Beschichtungen bewirken und dabei eine größtmögliche Reaktivität in ihrem Vermögen, die Härtung photopolymerisierbarer Systeme zu initiieren, zeigen und so bereits in geringen Einsatzkonzentrationen wirksam

sind.

Diese Aufgabe wurde gelöst durch die Bereitstellung von neuen, als Photoinitiatoren verwendbaren Gemischen, die im Vergleich zu den Einzelkomponenten eine beträchtlich gesteigerte Reaktivität in ihrem Vermögen, die Photopolymerisation ethylenisch ungesättigter Verbindungen bzw. die Härtung photopolymerisierbarer Systeme zu initiieren, zeigen. Darüber hinaus besitzen die erfindungsgemäßen Gemische eine gute Dunkellagerstabilität und den Vorteil der leichten Einarbeitbarkeit in das zu polymerisierende System, da diese Gemische im Gegensatz zur Thioxanthon-Komponente flüssig sind. Die mit Hilfe der erfindungsgemäßen Initiatorengemische ausgehärteten Polymerisate erfahren eine noch geringere Vergilbung als jene Polymerisate, die mit nur einer Einzelkomponente dieser Gemische erhalten werden.

Gegenstand der Erfindung sind somit als Photoinitiatoren verwendbare Gemische auf Basis von aromatisch-aliphatischen Ketonen, die dadurch gekennzeichnet sind, daß sie

A. mindestens ein Hydroxyalkylphenon der allgemeinen Formel I

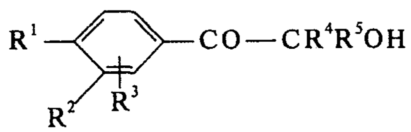

(I)

worin

$R^1$ H, Alkyl mit 1—4 C-Atomen oder Chlor,
$R^2$ H oder Methyl,
$R^3$ H oder Methyl,
$R^4$ Alkyl mit 1—6 C-Atomen, und
$R^5$ Alkyl mit 1—6 C-Atomen

bedeuten, sowie

B. mindestens ein 2-Alkylthioxanthon der allgemeinen Formel II

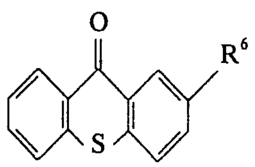

(II)

worin

$R^6$ Alkyl mit 1—8 C-Atomen bedeutet, enthalten.

Gegenstand der Erfindung ist auch die Verwendung dieser Gemische als Photoinitiatoren, insbesondere für die Photopolymerisation ethylenisch ungesättigter Verbindungen sowie für die UV-Härtung von Druckfarben.

Gegenstand der Erfindung ist ferner ein photopolymeriserbares System, enthaltend mindestens eine ethylenisch ungesättigte photopolymerisierbare Verbindung sowie gegebenenfalls weitere bekannte und übliche Zusatzstoffe, das dadurch gekennzeichnet ist, daß es ein Gemisch aus einem Hydroxyalkylphenon der allgemeinen Formel I und einem 2-Alkylthioxanthon der allgemeinen Formel II, vorzugsweise 0,1 bis 20 Gew.-% eines solchen Gemisches, als Photoinitiator enthält.

Gegenstand der Erfindung ist weiterhin ein Verfahren zur Photopolymerisation von ethylenisch ungesättigten Verbindungen, das dadurch gekennzeichnet ist, daß man dem zu polymerisierenden Gemisch vor der Auslösung der Photopolymerisation ein Gemisch aus einem Hydroxyalkylphenon der allgemeinen Formel I und einem 2-Alkylthioxanthon der allgemeinen Formel II, vorzugsweise 0,1 bis 20 Gew.-% eines solchen Gemisches, als Photoinitiator zusetzt.

Die Hydroxyalkylphenone der allgemeinen Formel I, Verfahren zu ihrer Herstellung und ihre photoinitiierende Wirksamkeit sind — wie bereits erwähnt — aus der DE-OS 2 722 264 bekannt. Diese zum überwiegenden Teil flüssigen Verbindungen sind in den üblichen photopolymeriserbaren Systemen gut löslich und besitzen eine gute Dunkellager- und chemische Stabilität.

2-Alkyltheoxanthone und ihre photoinitiierende Wirksamkeit sind ebenfalls seit langem bekannt. So werden beispielsweise in den US-Patentschriften 3 169 868 und 3 907 656 photopolymerisierbare Systeme beschrieben, die neben anderen Verbindungen auch Theoxanthone als Photoinitiatoren enthalten. Die Herstellung solcher 2-Alkylthioxanthone und ihre Eignung als Photoinitiatoren ist ferner in einem Übersichtsartikel über das UV-Härtungsverhalten einiger Photoinitiatoren und Photoaktivatoren in J. Oil Col. Chem. Assoc. 1978, 61, 256—263 beschrieben. Weitere Herstellungsverfahren sind bei-

spielsweise in der DE-OS 2 811 755 und in der US-PS 4 101 558 beschrieben. Die Verwendung von 2-Alkylthioxanthonen als alleinige Photoinitiatoren in einem photopolymerisierbaren System wird jedoch eingeschränkt durch verschiedene Nachteile, insbesondere die schlechte Löslichkeit der festen Thioxanthone in den jeweiligen Reaktionsgemischen und die starke Neigung zur Vergilbung der mit Hilfe von Thioxanthonen ausgehärteten Produkte.

Allgemeine Angaben über Photoinitiator-Gemische aus Hydroxyalkylphenon und weiteren bekannten Photoinitiatoren, wobei unter vielen anderen Verbindungen auch 2-Chlorthioxanthon genannt wird, sind bereits in der DE-OS 2 722 264 enthalten. Daraus konnte jedoch kein Hinweis auf die besonders vorteilhaften Eigenschaften der erfindungsgemäßen speziellen Gemische entnommen werden.

In der allgemeinen Formel I bedeutet $R^1$ vorzugsweise Wasserstoff, Methyl, i-Propyl, tert.-Butyl oder Chlor aber auch Ethyl, n-Propyl, n-Butyl oder sek.-Butyl. $R^2$ und $R^3$ sind vorzugsweise Wasserstoff. $R^4$ und $R^5$ sind vorzugsweise gleich, können aber auch verschieden sein. Sie bedeuten unverzweigtes oder verzweigtes Alkyl mit 1—6 C-Atomen, vorzugsweise mit 1—3 C-Atomen, insbesondere Methyl.

Dementsprechend sind die folgenden Verbindungen der allgemeinen Formel I bevorzugt:

1-Phenyl-2-hydroxy-2-methyl-propanon-(1),
1-(4'-Methylphenyl)-2-hydroxy-2-methyl-propanon-(1),
1-(4'-i-Propylphenyl)-2-hydroxy-2-methylpropanon-(1),
1-(4'-tert. Butylphenyl)-2-hydroxy-2-methyl-propanon-(1),
1-(4'-Chlorphenyl)-2-hydroxy-2-methyl-propanon-(1),
1-(3',4'-Dimethylphenyl)-2-hydroxy-2-methyl-propanon-(1),
1-Phenyl-2-hydroxy-2-methyl-butanon-(1)-,
1-Phenyl-2-hydroxy-2-ethyl-butanon-(1),
1-Phenyl-2-hydroxy-2-methyl-pentanon-(1).

In der allgemeinen Formel II bedeutet $R^6$ unverzweigtes oder verzweigtes Alkyl mit 1—8 C-Atomen, vorzugsweise mit 2—6 C-Atomen, insbesondere mit 3—5 C-Atomen. Beispiele für $R^6$ sind i-Propyl, n-Butyl, sek. Butyl, n-Pentyl, i-Pentyl, aber auch Methyl, Ethyl, n-Propyl, tert.-Butyl, 1-Methylbutyl, 2-Methylbutyl, 3-Methylbutyl, n-Hexyl, n-Heptyl, n-Octyl, 2-Ethylhexyl, 3,3-Dimethylbutyl.

Dementsprechend sind die folgenden Verbindungen der allgemeinen Formel II bevorzugt:

2-i-propylthioxanthon,
2-n-Butylthioxanthon,
2-n-pentylthioxanthon,
2-n-Hexylthioxanthon,
2-sek. Butylthioxanthon,
2-i-Pentylthioxanthon.

Die Herstellung der Verbindungen der allgemeinen Formel I ist aus J.Amer.Chem.Sec. 73, 4702 (1951), J. Gen.Chem. (USSR) 30, 792 (1960) Ber. 1967, 1047, Tetrahedron Letters 1972, 2423 sowie der DE-OS 2 722 264 bekannt. Vorzugsweise arbeitet man nach dem in der DE-OS 2 722 264 als bevorzugt genannten Herstellungsverfahren.

Die Herstellung der Verbindungen der allgemeinen Formel II wird beispielsweise in der CS-Patentschrift 113 698 (referiert in CA 64, 17 551 e), in J. Oil Col. ChPm. Assoc. 1978, 61, 256—263, in der DE-OS 2 811 755 und in der US-PS 4 101 558 beschrieben.

Die 2-Alkylthioxanthone der allgemeinen Formel II können den Hydroxyalkylphenonen der allgemeinen Formel I in Anteilen von 0,1 bis 99,9 Gew.-%, vorzugsweise von 0,1 Gew.-% bis zur Sättigungskonzentration zugemischt werden. Besonders vorteilhaft sind Gemische, die die beiden Einzelkomponenten A und B im Gewichtsverhältnis 99,9 : 0,1 bis 40 : 60 enthalten. Die so erhaltenen Gemische sind flüssig und besitzen dadurch den Vorteil der leichten Einarbeitsbarkeit in das zu polymerisierende System.

Die erfindungsgemäßen Gemische aus Hydroxyalkylphenonen der allgemeinen Formel I und 2-Alkylthioxanthonen der allgemeinen Formel II können gemäß der vorliegenden Erfindung als Photoinitiatoren für die Photopolymerisation ethylenisch ungesättigter Verbindungen bzw. für die Härtung photopolymerisierbarer Systeme, die solche Verbindungen enthalten, und insbesondere auch für die UV-Härtung von Druckfarben verwendet werden. Diese Verwendung erfolgt in üblicher Weise. Die erfindungsgemäßen Gemische werden zu polymerisierenden Systemen in der Regel in Mengen von 0,1 bis 20 Gew.-%, vorzugsweise 0,5 bis 12 Gew.-% zugesetzt. Dieser Zusatz geschieht in der Regel durch einfaches Lösen und Einrühren, da die meisten der zu polymerisierenden Systeme und die erfindungsgemäßen Gemische flüssig oder zumindest gut löslich sind. Unter einem zu polymerisierenden System wird ein Gemisch von durch freie Radikale initiiert polymerisierbaren mono- oder polyfunktionellen ethylenisch ungesättigten Monomeren, Oligomeren, Propolymeren, Polymeren oder Mischungen dieser Oligomeren, Prepolymeren und Polymeren mit ungesättigten Monomeren verstanden, das in der Regel weitere Zusätze, wie z. B. Antioxidantien, Lichtstabilisatoren, Farbstoffe, Pigmente, Reaktionsbeschleuniger enthalten kann. Als ungesättigte Verbindungen kommen alle diejenigen in Frage, deren C=C-Doppelbindungen durch zum Beispiel Halogenatome, Carbonyl-, Cyano-, Carboxy-, Ester-, Amid-, Ether- oder Arylgruppen oder durch konjugierte weitere Doppel- oder Dreifachbindungen aktiviert sind. Beispiele für solche Verbindungen sind Vinylchlorid, Vinylidenchlorid, Acrylnitril, Methacrylnitril, Acrylamid, Methycrylamid, Methyl-, Ethyl-, n- oder tert. Butyl-, Cyclohexyl-, 2-Ethylhexyl-, Benzyl-, Phenyloxyethyl-, Hydroxyethyl-, Hydroxypropyl-, niederes Alkoxyethyl-, Tetrahydrofurfurylacrylat oder -methacrylat, Vinylacetat, -propionat, -acrylat, -succinat, N-Vinylpyrrolidon, N-Vinylcarbazol, Styrol, Divinylbenzol, substituierte Styrole, sowie die Mischung von solchen ungesättigten Verbindungen. Auch mehrfach ungesättigte Verbindungen wie beispielsweise Ethylendiacrylat, 1,6-Hexandioldiacrylat, propoxyliertes Bisphenol-A-diacrylat und -dimethacrylat, Trimethylolpropandiacrylat und Pentaerythrittriacrylat können mit den erfindungsgemäßen Photoinitiatoren polymerisiert werden. Als photopolymerisierbare Verbindungen kommen weiterhin ungesättigte Oligomere, Prepolymere oder Polymere und deren Mischung mit ungesättigten Monomeren in Frage. Hierzu zählen beispielsweise ungesättigte Polyester, ungesättigte Acrylmaterialien, Epoximaterialien, Urethane, Silikone, Aminpolyamid-Harze und insbesondere acrylierte Harze wie acryliertes Silikonöl, acrylierter Polyester, acrylierte Urethane, acrylierte Polyamide, acryliertes Sojabohnenöl, acryliertes Epoxiharz, acryliertes Acrylharz, zweckmäßig im Gemisch mit einem oder mehreren Acrylaten eines Mono-, Di- oder Polyalkohols.

Die photopolymerisierbaren Verbindungen oder Systeme können in bekannter Weise durch den Zusatz thermischer Inhibitoren oder Antioxidantien, wie beispielsweise Hydrochinon oder Hydrochinonderivate, Pyrogallol, Thiophenole, Nitroverbindungen, β-Naphthylamine oder β-Naphthole in den üblichen Mengen stabilisiert werden, ohne daß dadurch die Initiatorwirkung der erfindungsgemäßen Gemische nennenswert beeinträchtigt wird. Durch solche Zusätze soll vor allem eine vorzeitige Polymerisation während der Herstellung der Systeme durch Mischen der Komponenten verhindert werden.

Weiterhin können geringe Mengen von Lichtstabilisatoren, wie beispielsweise Benzophenon-Derivate, Benztriazol-Derivate oder Phenylsalicylate, zugesetzt werden.

Um die inhibierende Wirkung des Luftsauerstoffs auszuschließen, setzt man den photopolymerisierbaren Systemen häufig auch Paraffine oder ähnliche wachsartige Stoffe zu. Infolge mangelnder Löslichkeit im Polymeren schwimmen diese bei Beginn der Polymerisation aus und bilden eine transparente Oberflächenschicht, die den Zutritt von Luft verhindert. Der Luftsauerstoff kann beispielsweise auch durch Einführung von autoxidablen Gruppen, wie z. B. Allylgruppen, in das zu härtende System desaktiviert werden.

Weiterhin können den photopolymerisierbaren Systemen bekannte Pigmente oder Farbstoffe, wie sie z. B. in photochemisch aushärtenden Druckfarben gebräuchlich sind, zugesetzt werden. In diesem Fall wird die Photoinitiatormenge höher gewählt, beispielsweise 6 bis 12 Gew.-%, während für farblose photopolymerisierbare Produkte 0,1 bis 3 Gew.-% in den meisten Fällen voll ausreichen. Je nach Verwendungszweck können weitere Füllstoffe, wie Talkum, Gips oder Kieselsäure, Fasern, organische Zusatzstoffe, wie Thixotropiemittel, Verlaufsmittel, weitere Bindemittel, Gleitmittel, Mattierungsmittel, Weichmacher, Netzmittel, Silikone zur Verbesserung der Oberflächenbeschaffenheit, Antiausschwimmittel oder geringe Mengen an Lösungsmittel zugesetzt werden.

Besonders vorteilhaft ist es, den als Photoinitiatoren verwendbaren Gemischen und den photopolymerisierbaren Systemen Reaktionsbeschleuniger zuzusetzen. Als solche Reaktionsbeschleuniger kommen beispielsweise organische Amine, Phosphine, Alkohole, und/oder Thiole, die alle mindestens eine zum Heteroatom α-ständige CH-Gruppe aufweisen, in Frage. Ganz besonders geeignet sind z. B. primäre, sekundäre und tertiäre aliphatische, aromatische, araliphatische oder heterocyclische Amine, wie sie z. B. in der US-PS 3 759 807 beschrieben sind. Beispiele für solche Amine sind Butylamin, Dibutylamin, Tributylamin, Cyclohexylamin, Benzyldimethylamin, Di-cyclohexylamin, Triethanolamin, N-Methyldiethanolamin, Phenyl-diethanolamin, Piperidin, Piperazin, Morpholin, Pyridin, Chinolin, p-Dimethylaminobenzoesäureethylester, p-Dimetylaminobenzoesäurebutylester, 4,4′-Bis-dimethylamino-benzophenon (Michlers Keton) oder 4,4′-Bis-diethylamino-benzophenon. Besonders bevorzugt sind tertiäre Amine wie beispielsweise Trimethylamin, Triethylamin, Tri-isopropylamin, Tributylamin, Octyl-dimethylamin, Dodecyl-dimethylamin, Triethanolamin, N-Methyl-diethanolamin, N-Butyl-diethanolamin, Tris(hydroxypropyl)amin, Dimethylaminobenzoesäurealkylester, Michlers Keton.

Weiterhin kommen als Reaktionsbeschleuniger beispielsweise Trialkylphosphine, sek. Alkohole und Thiole in Frage.

Als Photoinitiatoren verwendbare Gemische und photopolymerisierbare Systeme, die zusätzlich als Reaktionsbeschleuniger mindestens ein organisches Amin enthalten, stellen somit eine besonders bevorzugte Form der vorliegenden Erfindung dar.

In der Regel werden diese Reaktionsbeschleuniger dem erfindungsgemäßen Gemisch bzw. dem photopolymerisierbaren System in solchen Mengen zugesetzt, daß Reaktionsbeschleuniger und Einzelkomponente B des erfindungsgemäßen Gemisches im Gewichtsverhältnis 1 : 0,01 bis 1 : 10 vorliegen. Besonders bevorzugt ist ein Gewichtsverhältnis von Reaktionsbeschleuniger zu Komponente B von 1 : 0,05 bis 1 : 1.

Der Ausdruck »Photopolymerisation von ethylenisch ungesättigten Verbindungen« ist im weitesten

Sinn zu verstehen. Darunter fällt z. B. das weitere Polymerisieren oder das Quervernetzen von polymeren Materialien, z. B. von Prepolymeren, die Homo-, Co- und Terpolymerisation von einfachen Monomeren und auch die Kombination der genannten Reaktionsarten.

Die Photopolymerisation erfolgt nach bekannten Methoden durch Bestrahlen mit Licht oder UV-Strahlung des Wellenlängenbereichs von 250 bis 500 nm, vorzugsweise von 300 bis 400 nm. Als Strahlenquellen können Sonnenlicht oder künstliche Strahler verwendet werden. Vorteilhaft sind z. B. Quecksilber-Hochdruck-, -Mitteldruck- oder -Niederdrucklampen, Xenon- und Wolframlampen; Laser-Lichtquellen können ebenfalls eingesetzt werden.

Die erfindungsgemäßen Gemische können als Photoinitiatoren bei der UV-Härtung von dünnen Schichten, wie z. B. Papier-, Kunststoff- und Metallbeschichtungen eingesetzt werden und bieten besondere Vorteile als Initiatoren für die Photohärtung von Druckfarben und für photohärtbare Systeme zur Herstellung von Druckplatten.

Insbesondere die Photohärtung von Druckfarben hat eine große Bedeutung erlangt, da die Trocknungszeit des Bindemittels ein maßgeblicher Faktor für die Produktionsgeschwindigkeit graphischer Erzeugnisse ist und in der Größenordnung von Bruchteilen von Sekunden liegt. Bei der Herstellung von Druckplatten werden z. B. Gemische von löslichen linearen Polyamiden mit photopolymerisierbaren Monomeren, beispielsweise Acrylamiden, und einem Photoinitiator verwendet. Filme oder Platten aus diesen Systemen werden über das Negativ oder über das Positiv der Druckvorlage belichtet und die ungehärteten Anteile werden anschließend mit einem Lösungsmittel eluiert.

In den folgenden Beispielen werden die Herstellung und Verwendung der erfindungsgemäßen Gemische als Photoinitiatoren bei der Photopolymerisation ethylenisch ungesättigter Verbindungen näher beschrieben. Dabei sind Konzentrations- und Prozentangaben, soweit nichts anderes angegeben ist, auf das Gewicht bezogen.

## Beispiel A

Eine Harzmischung aus 100 Teilen Titandioxid (Anatas), 63,5 Teilen eines Urethanacrylat-Harzes (Uvimer® 530 der Firma Bayer, Leverkusen), 36,5 Teilen Butandiol-1,4-diacrylat und 4 Teilen N-Methyldiethanolamin wird nach Zusatz von 2,5% des Initiatorgemisches unter Gelblicht, um unkontrollierbare Tageslichteinflüsse auszuschalten, in einer Dicke von 15 µm auf Aluminiumfolie aufgebracht. Die anschließende Härtung dieser Filme erfolgt mit einem Minicure-Gerät (der Fa. Primarc ITP (England)), bei dem die Lackproben auf einem Transportband mit variabler Geschwindigkeit unter einer Hg-Hochdrucklampe (Strahlungsstärke 80 W/cm) vorbeibewegt und dabei bestrahlt werden. Durch Änderung der Bandgeschwindigkeit wird die Strahlendosis variiert.

In den folgenden Tabellen 1 bis 4 wird in den ersten Spalten die jeweilige Zusammensetzung des verwendeten Initiatorgemisches in Gew.-Teilen angegeben. In der letzten Spalte wird die Bandgeschwindigkeit (in m/Min) angegeben, bei der der Film noch derart ausgehärtet wird, daß mittels eines Bleistiftes der Härte 6 B keine Schichtverletzung mehr möglich ist. Der gleiche Härtegrad eines mit UV-Strahlung gehärteten Lacksystems wird — unter sonst gleichen Bedingungen — in umso kürzerer Bestrahlungszeit erhalten, je reaktiver das verwendete Initiatorgemisch ist.

Tabelle 1

| Zusammensetzung des verwendeten Initiatorgemisches<br>Teile<br>1-Phenyl-2-hydroxy-2-methyl-propanon-(1) | Teile<br>2-i-Propylthioxanthon | Bandgeschwindigkeit in m/Min |
|---|---|---|
| 100 | — | 20 |
| 99 | 1 | 40 |
| 95 | 5 | >250 |
| 90 | 10 | >250 |
| 80 | 20 | >250 |
| 60 | 40 | >250 |
| — | 100 | 15 |

Beispiel B

Eine Harzmischung aus 100 Teilen Titandioxid (Anatas), 63,5 Teilen eines Epoxacrylatharzes (Laromer® 2555 der Firma BASF, Ludwigshafen), 36,5 Teilen Butandiol 1,4-diacrylat und 4 Teilen N-Methyldiethanolamin wird mit 2,5 Gew. % des jeweiligen Initiatorgemisches versetzt und, wie in Beispiel A beschrieben, auf Aluminiumfolie aufgebracht und bestrahlt Dabei wurden folgende Resultate erhalten:

Tabelle 2

| Zusammensetzung des verwendeten Initiatorgemisches<br>Teile<br>1-Phenyl-2-hydroxy-2-methyl-propanon-(1) | Teile<br>1-(4'-Chlor-phenyl)-2-hydroxy-2-methyl-propanon-(1) | Teile<br>2-Methyl-thioxanthon | Teile<br>2-i-Propyl-thioxanthon | Bandgeschwindigkeit in m/Min |
|---|---|---|---|---|
| 100 | — | — | — | 4 |
| 99 | — | 1 | — | 20 |
| 95 | — | 5 | — | 45 |
| 85 | — | 15 | — | 55 |
| — | — | 100 | — | 20 |
| — | 100 | — | — | 2 |
| — | 99 | — | 1 | 20 |
| — | 90 | — | 10 | 40 |
| — | 60 | — | 40 | 35 |
| — | — | — | 100 | 10 |
| — | 99 | 1 | — | 20 |
| — | 85 | 15 | — | 50 |

Beispiel C

Eine Harzmischung aus 100 Teilen Titandioxid (Anatas), 63,5 Teilen SVP® 1928 (Harz der Firma Degussa, Frankfurt/M.), 36,5 Teilen Butandiol-1,4-diacrylat und 4 Teilen N-Methyldiethanolamin wird mit 2,5 Gew.-% des jeweiligen Initiatorgemisches versetzt und, wie in Beispiel A beschrieben, auf Aluminiumfolie aufgebracht und bestrahlt.

In der folgenden Tabelle 3 sind die Ergebnisse, die mit verschiedenen Photoinitiator-Gemischen erzielt wurden, zusammengestellt.

Tabelle 3

| Zusammensetzung des verwendeten Initiatorgemisches Teile 1-(4'-i-Propylphenyl)-2-hydroxy-2-methyl-propanon-(1) | Teile 2-i-Propylthioxanthon | Teile 2-Methylthioxanthon | Bandgeschwindigkeit in m/Min |
|---|---|---|---|
| 100 | – | – | 4 |
| 99 | 1 | – | 15 |
| 90 | 10 | – | 40 |
| 80 | 20 | – | 40 |
| 60 | 40 | – | 35 |
| – | 100 | – | 15 |
| 99 | – | 1 | 15 |
| 95 | – | 5 | 40 |
| 85 | – | 15 | 45 |
| – | – | 100 | 20 |

Beispiel D

Eine Harzmischung aus 45 Teilen eines Acrylatharzes (Plex® 6628-0 der Firma Röhm, Darmstadt), 18,5 Teilen eines weiteren Acrylatharzes (Plex® 6673-0 der Firma Röhm, Darmstadt), 36,5 Teilen Butandiol-1,4-diacrylat und 4 Teilen N-Methyldiethanolamin wird mit 2,5 Gew.-% des Initiatorgemisches versetzt und, wie in Beispiel A beschrieben, auf Aluminiumfolie aufgebracht und bestrahlt.

Die Resultate sind in Tabelle 4 zusammengefaßt.

Tabelle 4

| Zusammensetzung des verwendeten Initiatorgemisches Teile 1-(3',4'-Dimethylphenyl)-2-hydroxy-2-methyl-propanon-(1) | Teile 2-i-Propylthioxanthon | Teile 2-Methylthioxanthon | Bandgeschwindigkeit in m/Min |
|---|---|---|---|
| 100 | – | – | 10 |
| 99 | 1 | – | 25 |
| 90 | 10 | – | > 250 |
| 80 | 20 | – | > 250 |
| 60 | 40 | – | > 250 |
| – | 100 | – | 15 |
| 99 | – | 1 | 25 |
| 95 | – | 5 | > 250 |
| 85 | – | 15 | > 250 |
| – | – | 100 | 20 |

Beispiel E

Eine Harzmischung aus 100 Teilen Titandioxid (Anatas), 63,5 Teilen eines Epoxiacrylatharzes (Laromer® 2555 der Firma BASF, Ludwigshafen), 36,5 Teilen Butandiol-1,4-diacrylat und 4 Teilen N-Methyldiethanolamin wird mit 2,5 Gew.-% eines Gemisches aus 99,9 Teilen 1-Phenyl-2-hydroxy-2-methylpropanon-(1) und 0,1 Teilen 2-i-Propylthioxanthon versetzt und auf Aluminiumfolie aufgebracht. Nach Bestrahlung wird eine weiße, klebfreie, durchgehärtete Oberflächenbeschichtung erhalten.

Beispiel F

Eine Harzmischung aus 100 Teilen Titandioxid (Anatas), 63,5 Teilen eines Acrylatharzes (Plex® 6628-0 der Firma Röhm, Darmstadt), 18,5 Teilen eines weiteren Acrylatharzes (Plex® 6673-0 der Firma Röhm, Darmstadt), 36,5 Teilen-Butandiol-1,4-diacrylat und 4 Teilen N-Methyldiethanolamin wird mit 2,5 Gew.-% eines Gemisches aus 40 Teilen 1-(4-i-Propylphenyl)-2-hydroxy-2-methylpropanon-(1) und 60 Teilen i-Pentylthioxanthon versetzt und auf Aluminiumfolie aufgebracht. Der nach der Bestrahlung erhaltene Film ist klebfrei und kratzfest.

Beispiel G

63,5 Teile eines Epoxiacrylatharzes (Laromer® 8555 der Firma BASF, Ludwigshafen) werden mit 36,5 Teilen Butandioldiacrylat und 20 Teilen Heliogenblau auf einer Dreiwalze angetrieben. Zu der erhaltenen blauen Druckfarbe werden 2 Gew.-% eines Gemisches aus 90 Teilen 1-(4-Chlorphenyl)-2-hydroxy-2-methyl-propanon-(1) und 10 Teilen 2-Isopropylthioxanthon zugesetzt. Nach Verdrucken auf Kunstdruckpapier in 1 µm Stärke wird mit UV-Licht bestrahlt. Die erhaltenen Druckbogen sind sofort stapelfähig.

**Patentansprüche**

1. Als Photoinitiatoren verwendbare Gemische auf Basis von aromatisch-aliphatischen Ketonen, dadurch gekennzeichnet, daß sie

A. mindestens ein Hydroxyalkylphenon der allgemeinen Formel I

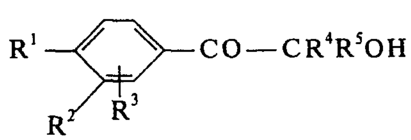

(I)

worin

$R^1$ H, Alkyl mit 1—4 C-Atomen oder Chlor,
$R^2$ H oder Methyl,
$R^3$ H oder Methyl,
$R^4$ Alkyl mit 1—6 C-Atomen, und
$R^5$ Alkyl mit 1—6 C-Atomen

bedeuten, sowie

B. mindestens ein 2-Alkylthioxanthon der allgemeinen Formel II

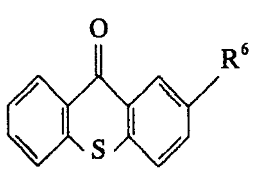

(II)

worin

$R^6$ Alkyl mit 1—8 C-Atomen bedeutet, enthalten.

2. Als Photoinitiatoren verwendbare Gemische nach Anspruch 1, dadurch gekennzeichnet, daß sie die Komponenten A und B im Gewichtsverhältnis von 99,9 : 0,1 bis 40 : 60 enthalten.

3. Als Photoinitiatoren verwendbare Gemische nach Anspruch 1 oder 2, dadurch gekennzeichnet, daß sie zusätzlich mindestens ein organisches Amin, das mindestens eine zum Stickstoffatom α-ständige CH-Gruppe aufweist, enthalten.

4. Verwendung von Gemischen nach den Ansprüchen 1 bis 3 als Photoinitiatoren.

5. Verwendung von Gemischen nach den Ansprüchen 1 bis 3, als Photoinitiatoren für die Photopolymerisation ethylenisch ungesättigter Verbindungen.

6. Verwendung von Gemischen nach den Ansprüchen 1 bis 3, als Photoinitiatoren für die UV-Härtung von Druckfarben.

7. Photopolymerisierbares System, enthaltend mindestens eine ethylenisch ungesättigte photopolymerisierbare Verbindung sowie gegebenenfalls weitere bekannte und übliche Zusatzstoffe, dadurch gekennzeichnet, daß es ein Gemisch nach den Ansprüchen 1 bis 3 als Photoinitiator enthält.

8. Photopolymerisierbares System nach Anspruch 7, dadurch gekennzeichnet, daß es 0,1 bis 20 Gew.-% eines Gemisches nach den Ansprüchen 1 bis 3 als Photoinitiator enthält.

9. Verfahren zur Photopolymerisation von ethylenisch ungesättigten Verbindungen, dadurch gekennzeichnet, daß man dem zu polymerisierenden Gemisch vor der Auslösung der Photopolymerisation ein Gemisch nach den Ansprüchen 1 bis 3 als Photoinitiator zusetzt.

10. Verfahren nach Anspruch 9, dadurch gekennzeichnet, daß man dem zu polymerisierenden Gemisch vor der Auslösung der Photopolymerisation 0,1 bis 20 Gew.-% eines Gemisches nach den Ansprüchen 1 bis 3 als Photoinitiator zusetzt.

## Claims

1. Mixtures which can be used as photoinitiators and are based on aromatic-aliphatic ketones, characterised in that the contain

A. at least one hydroxyalkylphenone of the general formula I

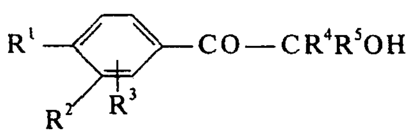 (I)

wherein

$R^1$ is H, alkyl having 1—4 C atoms or chlorine,
$R^2$ is H or methyl,
$R^3$ is H or methyl,
$R^4$ is alkyl having 1—6 C atoms, and
$R^5$ is alkyl having 1—6 C atoms, and

B. at least one 2-alkylthioxanthone of the general formula II

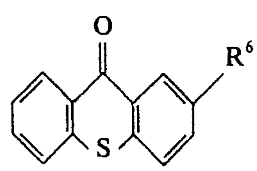 (II)

wherein $R^6$ is alkyl having 1—8 C atoms.

2. Mixture which can be used as photoinitiators, according to claim 1, characterised in that the contain the components A and B in a weight ratio of from 99,9 : 0,1 to 40 : 60.

3. Mixtures which can be used as photoinitiators, according to claim 1 or 2, characterised in that they additionally contain at least one organic amine which has at least one CH group in the α-position relative to the netrogen-atom.

4. Use of mixtures according to claims 1 to 3 as photoinitiators.

5. Use of mixtures according to claims 1 to 3 as photoinitiators for the photopolymerisation of ethylenically unsaturated compounds.

6. Use of mixtures according to claims 1 to 3 as photoinitiators for the ultraviolet hardening of printing inks.

7. Photopolymerisable system, containing at least one ethylenically unsaturated photopolymerisable compound and, if appropriate, further known and customary additives, characterised in that it contains a mixture according to claims 1 to 3 as the photoinitiator.

8. Photopolymerisable system according to claim 7, characterised in that it contains 0,1 to 20% by

weight of a mixture according to claims 1 to 3 as the photoinitiator.

9. Process for the photopolymerisation of ethylenically unsaturated compounds, characterised in that a mixture according to claims 1 to 3 is added as the photoinitiator to the mixture which is to be polymerised, before initiating the photopolymerisation.

10. Process according to claim 9, characterised in that 0,1 to 20% by weight of a mixture according to Claims 1 to 3 are added as the photoinitiator to the mixture which is to be polymerised, before initiating the photopolymerisation.

**Revendications**

1. Mélanges à base de cétones aromatico-aliphatiques, utilisables comme photo-initiateurs, caractérisés en ce qu'ils contiennent

A. au moins une hydroxyalkyl-phénone de formule génénerale I:

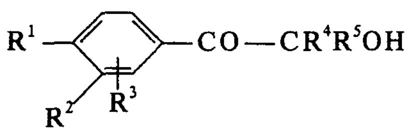

(I)

dans laquelle

$R^1$ représente H, un groupe alkyle contenant 1 à 4 Atomes de carbone ou un atome de chlore,
$R^2$ représente H ou un groupe méthyle,
$R^3$ représente H ou un groupe méthyle,
$R^4$ représente un groupe alkyle contenant 1 à 6 atomes de carbone, et
$R^5$ représente un groupe alkyle contenant 1 à 6 atomes de carbone,

ainsi que

B. au moins une 2-alkylthioxanthone de formule générale II:

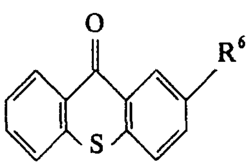

(II)

dans laquelle

$R^6$ représente un groupe alkyle contenant 1 à 8 atomes de carbone.

2. Mélanges utilisables comme photo-initiateurs suivant la revendication 1, caractérisés en ce qu'ils contiennent les composants A et B dans un rapport pondéral de 99,9 : 0,1 à 40 : 60.

3. Mélanges utilisables comme photo-initiateurs suivant la revendication 1 ou 2, caractérisés en ce qu'ils contiennent, en outre, au moins une amine organique comportant au moins un groupe CH en position $\alpha$ par rapport à l'atome d'azote.

4. Utilisation de mélanges suivant les revendications 1 à 3 comme photo-initiateurs.

5. Utilisation de mélanges suivant les revendications 1 à 3 comme photo-initiateurs pour la photopolymérisation de composés à insaturation éthylénique.

6. Utilisation de mélanges suivant les revendications 1 à 3, comme photo-initiateurs pour le durcissement d'encres d'impression à l'ultraviolet.

7. Système photopolymérisable contenant au moins un composé photopolymérisable à insaturation éthylénique, ainsi qu'éventuellement d'autres additifs habituels connus, caractérisé en ce qu'il contient un mélange suivant les revendications 1 à 3 comme photo-initiateur.

8. Système photopolymérisable suivant la revendication 7, caractérisé en ce qu'il contient 0,1 à 20% en poids d'un mélange suivant les revendications 1 à 3 comme photo-initiateur.

9. Procédé de photopolymérisation de composés à insaturation éthylénique, caractérisé en ce que, avant le déclenchement de la photopolymérisation, on ajoute, au mélange à polymériser, un mélange suivant les revendications 1 à 3 comme photo-initiateur.

10. Procédé suivant la revendication 9, caractérisé en ce que, avant le déclenchement de la photopolymérisation, au mélange à polymériser, on ajoute 0,1 à 20% en poids d'un mélange suivant les revendications 1 à 3 comme photo-initiateur.